# EUROPÄISCHE PATENTSCHRIFT

(11) **EP 1 782 665 B1**
(45) Veröffentlichungstag und Bekanntmachung des Hinweises auf die Patenterteilung: **16.01.2013**
(21) Anmeldenummer: 05772152.4
(22) Anmeldetag: 17.08.2005
(51) Int. Cl.: H05K 7/20, G06F 1/20, H01L 23/473

(54) **KÜHLUNGSANORDNUNG FÜR EIN ELEKTRISCHES GERÄT UND VERFAHREN ZUR FLÜSSIGKEITSKÜHLUNG**
COOLING ASSEMBLY FOR AN ELECTRICAL APPLIANCE, AND METHOD FOR COOLING LIQUID
SYSTEME DE REFROIDISSEMENT POUR APPAREIL ELECTRIQUE ET PROCEDE DE REFROIDISSEMENT DE LIQUIDE

(30) Priorität: 26.08.2004 DE 102004042034; 03.09.2004 DE 102004043398
(43) Veröffentlichungstag der Anmeldung: 09.05.2007
(73) Patentinhaber: Xylem IP Holdings LLC, White Plains, NY 10604 (US)
(72) Erfinder: LAING, Karsten, 71566 Althütte (DE)
(74) Vertreter: Hoeger, Stellrecht & Partner Patentanwälte
(86) Internationale Anmeldenummer: PCT/EP2005/008917
(87) Internationale Veröffentlichungsnummer: WO 2006/021359

(56) Entgegenhaltungen:
- US-A1- 2001 036 061
- US-A1- 2005 024 824
- US-B1- 6 313 990
- PATENT ABSTRACTS OF JAPAN Bd. 2000, Nr. 16, 8. Mai 2001 (2001-05-08) & JP 2001 015662 A (NIPPON KEIKI WORKS LTD), 19. Januar 2001 (2001-01-19)

## Beschreibung

Die Erfindung betrifft eine Kühlungsanordnung für ein elektrisches Gerät mit einer oder mehreren Wärmequellen, wobei das elektrische Gerät eine elektrische Energieversorgungsvorrichtung mit mindestens einer Wärmequelle aufweist, umfassend eine Lüftereinrichtung zur Kühlung der mindestens einen Wärmequelle der Energieversorgungsvorrichtung mittels eines Luftstroms, und eine Flüssigkeitskühlungseinrichtung.

Die Erfindung betrifft ferner ein Verfahren zur Flüssigkeitskühlung mindestens einer Wärmequelle eines elektrischen Geräts, bei dem ein Luftstrom einer Lüftereinrichtung einen Radiator beaufschlägt.

Flüssigkeitskühlungsvorrichtungen sind beispielsweise in der EP 1 398 511 A1 bzw. US 2004/011937 A1 oder der WO 03/098415 A1 beschrieben.

Aus der US 2001/036061 A1 ist ein elektronisches Gerät bekannt, welches ein Wärmetauschsystem für ein Festplattenlaufwerk umfasst mit einem geschlossenen Zirkulationssystem für ein flüssiges Kühlmittel.

Der Erfindung liegt die Aufgabe zugrunde, eine Kühlungsanordnung bereitzustellen, welche auf platzsparende Weise einsetzbar ist.

Diese Aufgabe wird bei der eingangs genannten Kühlungsanordnung erfindungsgemäß dadurch gelöst, daß die Lüfitereinrichtung so angeordnet ist, daß ein Radiator der Flüssigkeitskühlungseinrichtung mindestens teilweise mit einem Luftstrom der Lüftereinrichtung beaufschlagbar ist.

In dem Radiator der Flüssigkeitskühlungseinrichtung wird insbesondere über Vergrößerung der Fläche der Strömungsführung für einen Wärmetausch mit der Umgebung gesorgt, um aufgeheizte Kühlungsflüssigkeit wieder abkühlen zu können. Üblicherweise ist einem Radiator ein Lüfter zugeordnet, um den Radiator mit einem Luftstrom beaufschlagen zu können. Bei der erfindungsgemäßen Lösung sorgt die Lüftereinrichtung für eine Kühlung der Energieversorgungsvorrichtung und des Radiators. Die Anzahl der Baukomponenten läßt sich dadurch gering halten. Insbesondere muß nur eine einzige Lüftereinrichtung vorgesehen werden. Ein Lüfter der Lüftereinrichtung kann größer ausgebildet werden, so daß sich pro Lüfter auch das Lüftergeräusch minimieren läßt.

Es ist beispielsweise möglich, die Energieversorgungsvorrichtung lüfterfrei auszubilden. Dadurch kann die Energieversorgungsvorrichtung mit kleinerem Raumbedarf ausgebildet werden. Der bezogen auf ein gegebenes Gehäuse des elektrischen Geräts freiwerdende Raum kann dazu genutzt werden, die Flüssigkeitskühlungseinrichtung mit der Lüftereinrichtung (welche auch für eine Kühlung des Radiator sorgt) zu positionieren. Die Kühlungsanordnung läßt sich somit auf platzsparende Weise beispielsweise in einem Gehäuse eines elektrischen Geräts anordnen.

Grundsätzlich ist es auch möglich, daß der Radiator in die Energieversorgungsvorrichtung integriert ist.

Ganz besonders vorteilhaft ist es, wenn die Lüftereinrichtung und der Radiator in Beziehung zu der Energieversorgungsvorrichtung so angeordnet sind, daß die mindestens eine Wärmequelle der Energieversorgungsvorrichtung und der Radiator über die Lüftereinrichtung kühlbar sind. Ein Luftstrom der Lüftereinrichtung sorgt dann für eine Luftkühlung der Energieversorgungsvorrichtung und für eine Luftkühlung der Kühlungsflüssigkeit im Radiator. Dadurch erhält man eine platzsparende Ausbildung der Kühlungsanordnung mit einer effektiven Kühlung sowohl der Energieversorgungsvorrichtung als auch der Kühlungsflüssigkeit.

Beispielsweise läßt sich die Energieversorgungsvorrichtung lüfterfrei ausbilden. Die Energieversorgungsvorrichtung hat dann einen kleineren Platzbedarf im Vergleich zu Energieversorgungsvorrichtungen mit integriertem Lüfter. Dadurch wiederum wird beispielsweise in einem Gehäuse eines elektrischen Geräts ein Raum bereitgestellt, der für die Positionierung des Radiators genutzt werden kann und damit für die Positionierung mindestens von Komponenten der Flüssigkeitskühlungseinrichtung genutzt werden kann.

Insbesondere ist die Lüftereinrichtung in einem Raum neben der Energieversorgungsvorrichtung angeordnet. Dadurch läßt sich gewährleisten, daß der Luftstrom der Lüftereinrichtung die Energieversorgungsvorrichtung erreicht, um die Luftkühlung durchführen zu können. Weiterhin wird dann der beispielsweise durch Verkleinerung der Energieversorgungsvorrichtung bereitgestellte Raum effektiv genutzt.

Auch der Radiator ist günstigerweise in einem Raum neben der Energieversorgungsvorrichtung angeordnet.

Es kann vorgesehen sein, daß die Energieversorgungsvorrichtung und die Lüftereinrichtung an einem gemeinsamen Halter angeordnet sind. Dadurch lassen sich die Energieversorgungsvorrichtung und die Lüftereinrichtung auf einfache Weise beispielsweise in einem Gehäuse eines elektrischen Geräts montieren.

Aus dem gleichen Grund ist es günstig, wenn die Energieversorgungsvorrichtung und der Radiator an einem gemeinsamen Halter angeordnet sind bzw. die Lüftereinrichtung und der Radiator an einem gemeinsamen Halter angeordnet sind.

Es ist ferner günstig, wenn eine Umwälzpumpe der Flüssigkeitskühlungseinrichtung und die Energieversorgungsvorrichtung an einem gemeinsamen Halter angeordnet sind. Dadurch läßt sich die Kühlungsanordnung auf einfache Weise montieren.

Es ist grundsätzlich auch möglich, daß der Radiator in die Energieversorgungsvorrichtung integriert ist. Insbesondere ist dann auch die Lüftereinrichtung in die Energieversorgungseinrichtung integriert. Es läßt sich dadurch ein Kühlungs-Energieversorgungs-Modul bereitstellen, welches auf einfache Weise montierbar ist.

Besonders vorteilhaft ist es, wenn eine Umwälzpumpe für die Flüssigkeitskühlung vorgesehen ist und insbesondere in die Energieversorgungsvorrichtung integriert ist. Es läßt sich dadurch ein Modul bereitstellen, welches die notwendigen Komponenten für die Flüssigkeitskühlung enthält; dadurch läßt sich die Flüssigkeitskühlungseinrichtung auf einfache Weise an dem elektrischen Gerät montieren und auch einsetzen.

Es kann vorgesehen sein, daß die Umwälzpumpe an einem Gehäuse der Energieversorgungsvorrichtung angeordnet ist. Es läßt sich dann ein Energieversorgungs-Flüssigkeitskühlungs-Modul bereitstellen, wobei die Umwälzpumpe bereits positioniert ist. Das Gehäuse der Energieversorgungsvorrichtung stellt einen geeigneten Montageort für die Umwälzpumpe bereit.

Insbesondere ist die Umwälzpumpe außerhalb eines Gehäuseinnenraums eines Gehäuses der Energieversorgungsvorrichtung angeordnet. Die Umwälzpumpe läßt sich dann auf einfache Weise bezüglich der Energieversorgungsvorrichtung positionieren und montieren. Die Energieversorgungsvorrichtung läßt sich platzsparend ausbilden. Wenn Wartungsarbeiten an der Umwälzpumpe durchgeführt werden müssen bzw. die Umwälzpumpe ausgetauscht werden muß, dann läßt sich dies auf einfache Weise durchführen.

Ganz besonders vorteilhaft ist es, wenn die Umwälzpumpe mit mindestens einem thermischen Kontaktelement verbunden ist. Das thermische Kontaktelement, welches mit der Umwälzpumpe insbesondere über flexible schlauchförmige Flüssigkeitsleitungen verbunden ist, kann dann an einem oder mehreren relevanten Gegenständen des elektrischen Geräts in thermischem Kontakt fixiert werden. Beispielsweise kann es an der CPU eines Computers und einem Graphikprozessor positioniert werden, um für deren Kühlung zu sorgen.

Insbesondere ist mindestens ein thermisches Kontaktelement über Flüssigkeitsleitungen mit der Umwälzpumpe derart verbunden, daß durch das mindestens eine thermische Kontaktelement ein Gegenstand thermisch kontaktierbar ist. Flüssigkeitsleitungen, an denen das (mindestens eine) thermische Kontaktelement angeordnet ist, sind von der Energieversorgungsvorrichtung mit integrierter Umwälzpumpe herausgeführt. Die Energieversorgungsvorrichtung wird beispielsweise in dem Gehäuse des elektrischen Geräts montiert. Das thermische Kontaktelement wird dann an dem Gegenstand wie einer CPU oder einem Graphikprozessor positioniert und dort fixiert. Die Gesamtmontage ist stark vereinfacht, da die einzelnen Komponenten der Flüssigkeitskühlungseinrichtung nicht getrennt in dem Gehäuse des elektrischen Geräts montiert werden müssen.

Es gibt grundsätzlich zwei Möglichkeiten, die Umwälzpumpe und den Radiator in einer Strömungsführung relativ zueinander anzuordnen. Bezogen auf die Strömungsrichtung von aufgeheizter Kühlungsflüssigkeit, das heißt in der Strömungsrichtung von Kühlungsflüssigkeit, welche von einem thermischen Kontaktelement abströmt, kann der Radiator vor der Umwälzpumpe angeordnet sein oder nach der Umwälzpumpe. Günstig ist es, wenn in der Strömungsführung für Kühlungsflüssigkeit bezogen auf eine Strömungsrichtung für aufgeheizte Kühlungsflüssigkeit die Umwälzpumpe vor dem Radiator angeordnet ist, das heißt die Umwälzpumpe auf das thermische Kontaktelement folgt.

Die Umwälzpumpe wird dann von aufgeheizter Kühlungsflüssigkeit durchströmt, die nachfolgend in dem Radiator abgekühlt wird. Abgekühlte Kühlungsflüssigkeit wird dann von dem Radiator direkt einem thermischen Kontaktelement zugeführt. Eine solche Strömungsführung ist energetisch günstig.

Es ist insbesondere vorgesehen, daß die Umwälzpumpe an oder in der Nähe einer Durchtrittsführung für einen Kabelstrang angeordnet ist. Ein Kabelstrang muß über einen Durchtritt durch ein Gehäuse einer Energieversorgungsvorrichtung geführt werden. Der Kabelstrang enthält die Kabel, über die interne elektrische Verbraucher des elektrischen Geräts mit Strom versorgt werden. Der aus der Energieversorgungsvorrichtung austretende Kabelstrang benötigt Raum. Deshalb muß ein bestimmter Raum hinter der Energieversorgungsvorrichtung für den Kabelstrang freigehalten werden. Wenn die Umwälzpumpe (und gegebenenfalls auch ein Ausgleichsbehälter) an oder in der Nähe zur Durchführung angeordnet sind, dann kann dieser sowieso freizuhaltende Raum effektiv genutzt werden. Der effektive Raumbedarf der Kühlungsanordnung läßt sich dadurch gering halten.

Insbesondere ist die Umwälzpumpe an einer Halteplatte angeordnet, welche einem elektrischen Anschluß gegenüberliegt. Über den elektrischen Anschluß wird elektrische Energie von außen in die Energieversorgungsvorrichtung eingekoppelt. Üblicherweise ist der elektrische Anschluß ein Netzanschluß. An der Halteplatte ist üblicherweise ein Durchtritt für einen Kabelstrang angeordnet. Hinter dem Kabelstrang muß sowieso Platz gehalten werden, um diesen herausführen zu können. Wenn dann die Umwälzpumpe an der Halteplatte angeordnet wird, dann kann dieser Platz in einem Gehäuse eines elektrischen Geräts zur Aufnahme der Umwälzpumpe genutzt werden.

Ganz besonders vorteilhaft ist es, wenn der Radiator und die Lüftereinrichtung hintereinander angeordnet sind, wobei der Radiator bezüglich einer Ansaugseite vor oder hinter der Lüftereinrichtung angeordnet sein kann. Durch die Hintereinanderanordnung von Radiator und Lüftereinrichtung ist gewährleistet, daß der Radiator über den Luftstrom der Lüftereinrichtung kühlbar ist.

Insbesondere ist es günstig, wenn der Radiator unterhalb eines elektrischen Anschlusses der Energieversorgungsvorrichtung angeordnet ist. Dadurch läßt sich eine Luftzirkulation durch einen Innenraum der Energieversorgungsvorrichtung gewährleisten. Üblicherweise sind Öffnungen und insbesondere Lüftungsschlitze einer Energieversorgungsvorrichtung neben dem elektrischen Anschluß angeordnet. Wenn der Radiator unterhalb des elektrischen Anschlusses liegt, dann sind solche Lüftungsschlitze nicht vollständig bedeckt.

Es kann vorgesehen sein, daß eine Rotationsachse der Lüftereinrichtung quer zu einer Rotationsachse der Umwälzpumpe orientiert ist. Dadurch läßt sich eine platzsparende Integration der Flüssigkeitskühlungseinrichtung in die Energieversorgungsvorrichtung realisieren.

Günstig ist es, wenn die Umwälzpumpe einen Elektromotor mit einem sphärisch gelagerten Rotor aufweist. Solche Umwälzpumpen sind in der EP 1 416 607 A2 bzw. US 2004/0119371 A1 und der EP 1 398 511 A1 bzw. US 2004/0052663 A1 beschrieben, auf die ausdrücklich Bezug genommen wird. Solche Elektromotoren und damit die Umwälzpumpen, in welche solche Elektromotoren integriert sind, lassen sich mit geringer Höhe ausbilden. Ferner weisen die entsprechenden Elektromotoren eine hohe Laufruhe auf, so daß die Geräuschemission reduziert ist. Ferner weisen entsprechende Elektromotoren eine hohe Lebensdauer auf.

Insbesondere ist ein Schaufelrad der Umwälzpumpe mit dem Rotor verbunden, welcher das Schaufelrad entsprechend antreibt.

Es ist günstig, wenn mindestens ein Ausgleichsbehälter für Kühlungsflüssigkeit vorgesehen ist. Es ergibt sich dadurch die Möglichkeit, die Flüssigkeitskühlungseinrichtung mit einer größeren Menge an Kühlurigsflüssigkeit zu befüllen, als für den aktuellen Betrieb notwendig ist. Es kann dadurch ein normaler Kühlungsflüssigkeitsschwund beispielsweise durch Diffusion und Verdunstung ausgeglichen werden, so daß bei genügender Vorbefüllung eine Nachbefüllung während der Lebensdauer der Flüssigkeitskühlungseinrichtung nicht notwendig ist.

Insbesondere ist der mindestens eine Ausgleichsbehälter in die Energieversorgungsvorrichtung integriert. Es ist dadurch ein Gesamtsystem bereitgestellt, welches die notwendigen Komponenten für die Flüssigkeitskühlung enthält.

Es kann auch vorgesehen sein, daß der mindestens eine Ausgleichsbehälter in die Umwälzpumpe integriert ist, das heißt insbesondere innerhalb eines Gehäuses der Umwälzpumpe angeordnet ist.

Insbesondere umfaßt die Kühlungsanordnung die Komponenten Radiator, Umwälzpumpe, Ausdehnungsbehälter und die Lüftereinrichtung.

Es ist ferner günstig, wenn ausgehende Flüssigkeitsleitungen vorhanden sind, an welchen mindestens ein thermisches Kontaktelement angeordnet ist. Die Flüssigkeitsleitungen sind insbesondere flexibel als Schläuche ausgebildet. Es lassen sich dann ein oder mehrere thermische Kontaktelemente bezüglich einem oder mehreren zu kühlenden Gegenständen positionieren.

Es ist besonders vorteilhaft, wenn die Flüssigkeitskühlungseinrichtung mit einer solchen Menge an Kühlungsflüssigkeit vorbefüllt ist, daß kein Nachfüllen für eine erwartete Lebensdauer notwendig ist. Die Flüssigkeitskühlungseinrichtung enthält als vorkonfektioniertes System diejenige Menge an Kühlungsflüssigkeit (beispielsweise ein Wasser-Gefrierschutz-Gemisch), so daß Kühlungsflüssigkeitsverluste beispielsweise durch Diffusion und Verdunstung ausgleichbar sind.

Der Erfindung liegt ferner die Aufgabe zugrunde, ein Verfahren der eingangs genannten Art bereitzustellen, mittels welchem sich eine effektive Kühlung erreichen läßt.

Diese Aufgabe wird bei dem eingangs genannten Verfahren erfindungsgemäß dadurch gelöst, daß ein Luftstrom der Lüftereinrichtung auch eine Energieversorgungsvorrichtung des elektrischen Geräts so beaufschlägt, daß eine oder mehrere Wärmequellen der Energieversorgungsvorrichtung mittels des Luftstroms gekühlt werden.

Das erfindungsgemäße Verfahren weist die bereits im Zusammenhang mit der erfindungsgemäßen Kühlungsanordnung erläuterten Vorteile auf.

Weitere vorteilhafte Ausgestaltungen wurden ebenfalls bereits im Zusammenhang mit der erfindungsgemäßen Kühlungsanordnung erläutert.

Die nachfolgende Beschreibung einer bevorzugten Ausführungsform dient im Zusammenhang mit der Zeichnung der näheren Erläuterung der Erfindung. Es zeigen:
- Figur 1: eine seitliche Schnittansicht eines Ausführungsbeispiels einer erfindungsgemäßen Kühlungsanordnung;
- Figur 2: eine Ansicht der Kühlungsanordnung gemäß Figur 1 in der Richtung A ohne Lüftereinrichtung;
- Figur 3: die gleiche Ansicht wie in Figur 2 mit Lüftereinrichtung (ohne Flüssigkeitsleitungen);
- Figur 4: eine Ansicht auf die Kühlungsanordnung gemäß Figur 1 in der Richtung B und
- Figur 5: eine Ansicht der Kühlungsanordnung gemäß Figur 1 in der Richtung C (Gegenrichtung zu Richtung B).

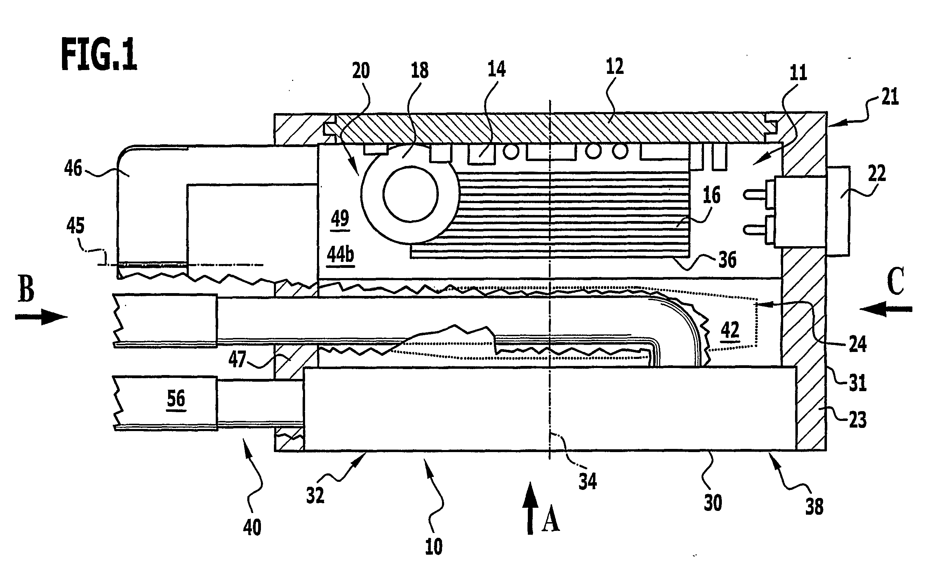

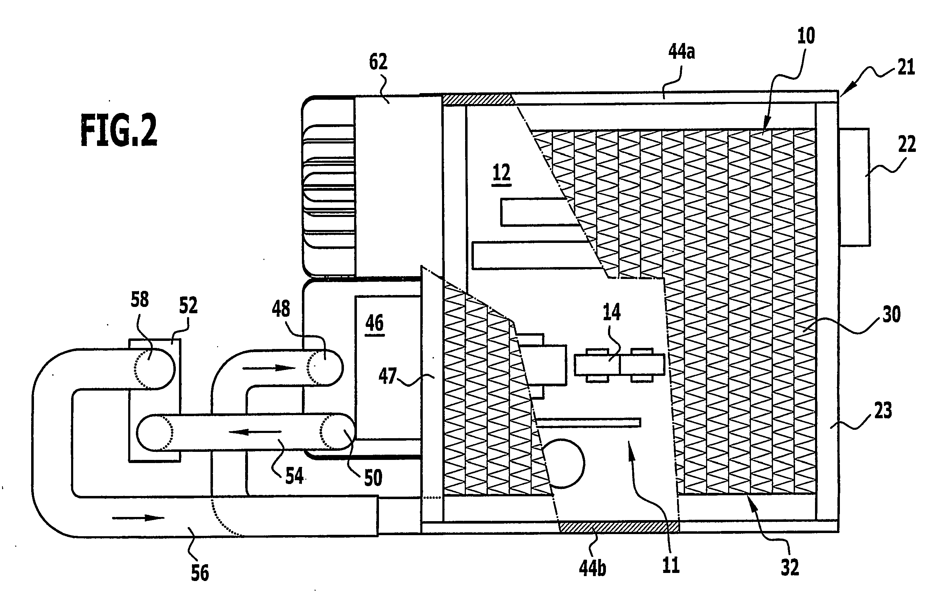

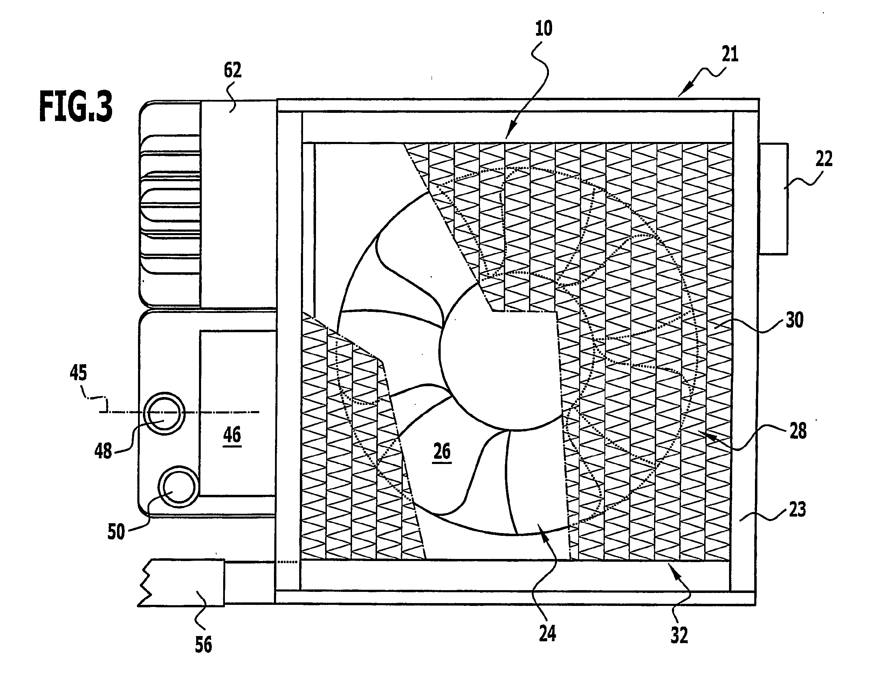

Ein Ausführungsbeispiel einer erfindungsgemäßen Kühlungsanordnung ist in den Figuren 1 bis 5 gezeigt und ist dort mit 10 bezeichnet. Sie dient zur Kühlung eines elektrischen Geräts. Insbesondere werden Wärmequellen des elektrischen Geräts gekühlt. Die Kühlungsanordnung 10 ist beispielsweise in einem Gehäuse des elektrischen Geräts positioniert.

Das elektrische Gerät umfaßt eine Energieversorgungsvorrichtung 11 zur Bereitstellung von elektrischer Energie an interne elektrische Verbraucher des elektrischen Geräts in der geeigneten Form.

Die Energieversorgungsvorrichtung 11 umfaßt beispielsweise einen Träger 12 für funktionelle Komponenten 14 der Energieversorgungsvorrichtung 11. Insbesondere sind an dem Träger 12 elektronische Bauteile als funktionelle Komponenten 14 angeordnet. An dem Träger 12 kann auch ein Kühlkörper 16 angeordnet sein. Dieser Kühlkörper 16, welcher eine Mehrzahl von Kühlrippen aufweist, steht in thermischem Kontakt mit einem oder mehreren elektronischen Leistungsbauteilen 18 einer auf dem Träger 12 angeordneten Schaltungsanordnung 20. Der Kühlkörper 16 ist eine sekundäre Wärmequelle, wobei ein oder mehrere elektronische Bauelemente, welche im Betrieb heiß werden, entsprechende primäre Wärmequellen sind.

Die Energieversorgungsvorrichtung 11 weist ein geschlossenes Gehäuse 21 auf, in welchem die Schaltungsanordnung 20 sitzt. Bei dem Gehäuse 21 handelt es sich insbesondere um ein Stahlgehäuse. Das Gehäuse 21 ist so ausgebildet, daß es durch einen (Kühl-)Luftstrom durchströmbar ist.

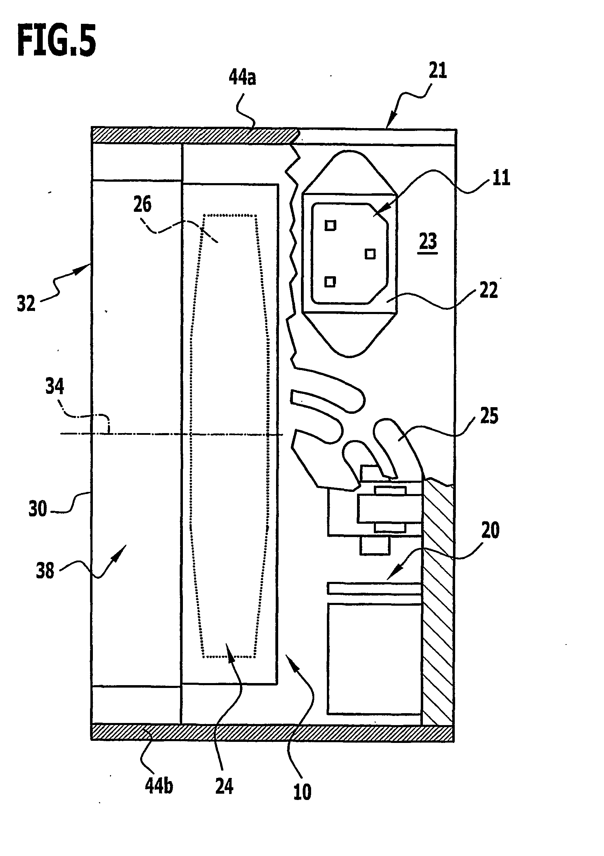

Die elektrische Energieversorgungsvorrichtung 11 weist einen elektrischen Anschluß 22 für die externe Stromzuführung auf, bei dem es sich insbesondere um einen Netzanschluß handelt. Dieser ist an einer Rückenplatte 23 des Gehäuses 21 angeordnet. Die Rückenplatte 23 ist mit Öffnungen 25 versehen (Figur 5), welche neben dem elektrischen Anschluß 22 angeordnet sind. Über den elektrischen Anschuß 22 läßt sich elektrische Energie in die Energieversorgungsvorrichtung 11 einkoppeln, wobei die Energieversorgungsvorrichtung 11 mit ihrer Schaltungsanordnung 20 für eine elektrische Wandlung sorgt, so daß elektrische Energie elektronischen Komponenten eines elektrischen Gerätes, wie beispielsweise einem Computer und insbesondere PC, in der erforderlichen Form bereitstellbar ist.

Der Energieversorgungsvorrichtung 11 ist eine Lüftereinrichtung 24 mit einem rotierend angetriebenen Lüfterrad 26 eines Lüfters 28 zugeordnet. Vor dem Lüfterrad 26 ist ein Schutzgitter 30 angeordnet.

Die Energieversorgungsvorrichtung 11 und die Lüftereinrichtung 24 können an einem gemeinsamen Halter 31 angeordnet sein. Insbesondere ist die Lüftereinrichtung 24 in einem Raum neben der Energieversorgungsvorrichtung 11 angeordnet.

Über eine Ansaugseite 32, welche (abgedeckt mit dem Schutzgitter 30) mindestens teilweise offen ist, ist ein Kühlungs-Luftstrom erzeugbar. Die Ansaugseite 32 ist quer und insbesondere senkrecht zur Rückenplatte 23 orientiert. Der Lüfter 28 ist so angeordnet, daß über den Luftstrom insbesondere der Kühlkörper 16 kühlbar ist. Beispielsweise ist der Luftstrom auch so gerichtet, daß er mindestens teilweise auch Leistungsbauteile 18 direkt beaufschlägt.

Bei dem gezeigten Ausführungsbeispiel ist eine Rotationsachse 34 des Lüfterrads 26 quer und insbesondere senkrecht auf eine Seitenfläche 36 des Kühlkörpers 16 ausgerichtet. Weiterhin ist die Rotationsachse 34 quer und insbesondere senkrecht zu dem Träger 12 für die Schaltungsanordnung 20 ausgerichtet. Ferner ist die Rotationsachse 34 insbesondere parallel zu der Rückenplatte 23 orientiert.

Bei der Positionierung der Energieversorgungsvorrichtung 11 in einem Gehäuse des entsprechenden elektrischen Geräts, für dessen Energieversorgung sie verantwortlich ist, weist die Ansaugseite 32 vorzugsweise nach unten ins Gehäuseinnere. Insbesondere ist das Gehäuse des elektrischen Geräts mit einer Öffnung versehen, an welcher die Rückenplatte 23 der Energieversorgungsvorrichtung 11 positioniert wird. Diese Öffnung liegt üblicherweise an einer Gehäuserückseite des elektrischen Geräts.

Erfindungsgemäß ist es vorgesehen, daß ein Radiator 38 einer Flüssigkeitskühlungseinrichtung 40 so angeordnet ist, daß er (d.h. die Flüssigkeit, welche durch den Radiator 38 strömt) über die Lüftereinrichtung 24 kühlbar ist.

Insbesondere ist der Radiator 38 so angeordnet, daß er mindestens teilweise durch den Luftstrom der Lüftereinrichtung 24 beaufschlagbar ist, um für eine Kühlung zu sorgen.

Durch die insbesondere als Lüftungsschlitze ausgebildete Öffnungen 25 ist eine Luftzirkulation mit dem Außenraum ermöglicht. Dadurch wird ein Luftstau in dem Gehäuse des elektrischen Geräts vermieden.

Der Radiator 38 weist eine Kühlstrecke 42 auf, durch die (aufgeheizte) Flüssigkeit strömt. In der Kühlstrecke 42 kann sich die Flüssigkeit insbesondere aufgrund der Luftstrombeaufschlagung durch die Lüftereinrichtung 24 abkühlen.

Bei der erfindungsgemäßen Lösung ist eine gemeinsame Lüftereinrichtung, nämlich die Lüftereinrichtung 24, für die Energieversorgungsvorrichtung 11 und für die Flüssigkeitskühlungseinrichtung 40, vorgesehen. Das Lüfterrad 26 läßt sich größer ausbilden; dadurch läßt sich die Geräuschentwicklung der Lüftereinrichtung 24 erniedrigen.

Zum Halten des Radiators 38 sind beispielsweise gegenüberliegende Halter 44a, 44b vorgesehen. Die Halter 44a, 44b können auch die Lüftereinrichtung 24 halten. Sie sind beispielsweise an dem Gehäuse 21 fixiert.

Bei der Kühlungsanordnung 10 sind der Radiator 38 und die Lüftereinrichtung 24 hintereinander angeordnet, so daß der Luftstrom der Lüftereinrichtung 24 an der Kühlstrecke 42 vorbeiströmt. Bezogen auf das Schutzgitter 30 kann die Lüftereinrichtung 24 vor oder hinter dem Radiator 38 angeordnet sein. Der Radiator 38 ist vorzugsweise mechanisch geschützt angeordnet.

Es kann beispielsweise vorgesehen sein, daß der Radiator 38 nur einen Teilbereich der Strömungsfläche der Lüftereinrichtung 24 "bedeckt", so daß über einen anderen Teilbereich der Luftstrom des Lüfters 28 direkt den Kühlkörper 16 beaufschlagen kann.

Eine Umwälzpumpe 46 der Flüssigkeitskühlungseinrichtung 40 ist in einem Raum neben der Energieversorgungsvorrichtung 11 positioniert. Bei der Umwälzpumpe 46 handelt sich beispielsweise um eine Umwälzpumpe mit einem sphärisch gelagerten Rotor, an welchem drehfest ein Schaufelrad sitzt. Eine solche Umwälzpumpe ist beispielsweise in der EP 1 398 511 A1 bzw. der US 2004/0052663 A1 oder der EP 1 416 607 A2 bzw. der US 2004/0119371 A1 beschrieben. Auf diese Druckschriften wird ausdrücklich Bezug genommen.

Eine Rotationsachse 45 des Rotors der Umwälzpumpe liegt quer und insbesondere senkrecht zur Rotationsachse 34 des Lüfterrads 26.

Es kann vorgesehen sein, daß die Kühlungsanordnung 10 mit der Lüftereinrichtung 24 und der Flüssigkeitskühlungseinrichtung 40 ein Kühlungsmodul bildet, welches in einem Gehäuse des entsprechenden elektrischen Geräts (beispielsweise eines Computers) einsetzbar ist. Dieses Modul kann auch noch die Energieversorgungsvorrichtung 11 umfassen.

Die Umwälzpumpe 46 ist beispielsweise an einer Halteplatte 47 der Energieversorgungsvorrichtung 11, welche der Rückenplatte 23 gegenüberliegt und zwischen den Haltern 44a, 44b sitzt, fixiert. Insbesondere ist sie außerhalb eines Gehäuseinnenraums 49 des Gehäuses 21 angeordnet.

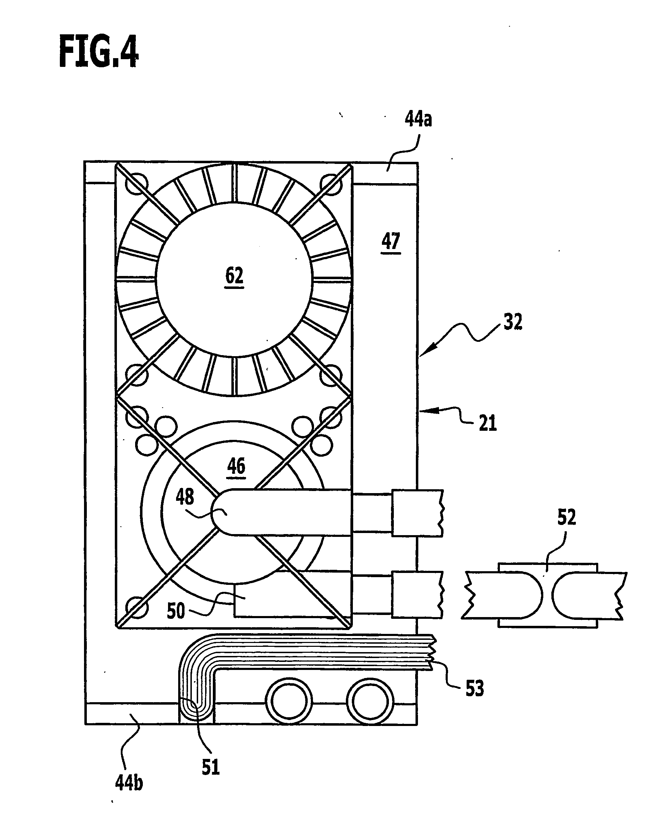

An der Halteplatte 47 ist eine Durchführung 51 für einen oder mehrere Kabelstränge 53 gebildet (Figur 4). Über diesen Kabelstrang 53 (bzw. Kabelstränge 53) wird elektrischen Verbrauchern des elektrischen Geräts Strom zugeführt.

Die Umwälzpumpe 46 wird über die elektrische Energieversorgungsvorrichtung 11 mit elektrischer Energie versorgt. Sie ist dazu an entsprechende Ausgangsanschlüsse der Schaltungsanordnung 20 beispielsweise mittels Kabel des Kabelstrangs 53 elektrisch angeschlossen.

Die Umwälzpumpe 46 weist einen ersten Flüssigkeitsanschluß 48 und einen zweiten Flüssigkeitsanschluß 50 auf. Mit diesen beiden Anschlüssen 48, 50 steht (mindestens) ein thermisches Kontaktelement 52 in fluidwirksamer Verbindung, welches an einem oder mehreren elektronischen Leistungsbauteilen (welche Wärmequellen sind) des elektrischen Geräts fixierbar ist, um Wärme abführen zu können.

Beispielsweise ist es vorgesehen, das thermische Kontaktelement 52 an der CPU eines Computers in thermischem Kontakt mit dieser zu fixieren. Es kann alternativ oder zusätzlich auch vorgesehen sein, das thermische Kontaktelement 52 oder ein weiteres thermisches Kontaktelement mit einem Graphikprozessor eines Computers thermisch zu verbinden.

Das thermische Kontaktelement 52 dient dazu, den thermischen Kontakt mit einer Wärmequelle (heat sink) bereitzustellen. Das thermische Kontaktelement 52 wird von Kühlungsflüssigkeit durchströmt, um Wärme von dem thermischen Kontaktelement 52 und damit von der Wärmequelle abführen zu können.

Das thermische Kontaktelement 52 ist mit dem zweiten Flüssigkeitsanschluß 50 der Umwälzpumpe 46 über eine erste Flüssigkeitsleitung 54 verbunden. Bei dieser handelt es sich insbesondere um einen (flexiblen) Schlauch.

Das thermische Kontaktelement 52 ist ferner über eine zweite Flüssigkeitsleitung 56 mit dem ersten Flüssigkeitsanschluß 48 der Umwälzpumpe 46 verbunden.

Zwischen einem entsprechenden Anschluß 58 des thermischen Kontaktelements 52 und dem ersten Flüssigkeitsanschluß 48 der Umwälzpumpe 46 ist der Radiator 38 angeordnet; aufgeheizte Kühlungsflüssigkeit, welche vom thermischen Kontaktelement 52 kommt, läßt sich in dem Radiator 38 mit seiner flächigen Kühlstrecke 42 abkühlen, so daß abgekühlte Kühlungsflüssigkeit der Umwälzpumpe 46 über den Flüssigkeitsanschluß 48 zuführbar ist.

Es ist auch möglich, daß der Anschluß 58 des thermischen Kontaktelements 52 mit der Umwälzpumpe 46 über den Anschluß 48 verbunden ist. Der Anschluß 50 ist dann mit dem Radiator 38 verbunden. In der Strömungsführung der Kühlungsflüssigkeit ist die Umwälzpumpe 46 dann direkt nach dem thermischen Kontaktelement 52 und vor dem Radiator 38 angeordnet. Die Umwälzpumpe 46 wird dadurch von aufgeheizter Kühlungsflüssigkeit vor dem Abkühlen im Radiator 38 durchströmt.

Die Umwälzpumpe kann auch mehrere thermische Kontaktelemente mit Kühlungsflüssigkeit versorgen bzw. es sind mehrere Umwälzpumpen vorgesehen.

Die Flüssigkeitskühlungseinrichtung 40 umfaßt einen Ausgleichsbehälter 62 für Kühlungsflüssigkeit. Es kann sich dabei um einen getrennten Behälter handeln, wie in den Figuren gezeigt, oder der Ausgleichsbehälter kann in die Umwälzpumpe 46 integriert sein.

Der Ausdehnungsbehälter 62 weist beispielsweise ein Aufnahmevolumen in der Größenordnung von 50 cm³ auf. Er ist insbesondere neben der Umwälzpumpe 46 an der Halteplatte 47 angeordnet.

Die Flüssigkeitskühlungseinrichtung 40 wird vorzugsweise mit der erforderlichen Menge an Kühlungsflüssigkeit vorbefüllt, welche für die erwartete übliche Lebensdauer ausreicht, so daß keine Nachbefüllung notwendig ist. Der Ausgleichsbehälter 62 stellt den zusätzlichen Aufnahmeraum für die Kühlungsflüssigkeit hierzu bereit.

Erfindungsgemäß wird eine Kühlungsanordnung bereitgestellt, welche einfach und platzsparend aufgebaut ist. Über die erfindungsgemäße Kühlungsanordnung lassen sich Wärmequellen eines elektrischen Geräts flüssigkeitskühlen und über einen Luftstrom kühlen. Insbesondere wird mindestens eine Wärmequelle der Energieversorgungsvorrichtung 11 des elektrischen Geräts über die Lüftereinrichtung 24 gekühlt, welche gleichzeitig für eine Luftstromkühlung des Radiators 38 sorgt.

Das oder die thermischen Kontaktelemente 52 werden dann mit den zu kühlenden Gegenständen des elektrischen Gerätes, insbesondere mit elektronischen Leistungsbauteilen, in thermischen Kontakt gebracht, das heißt bezüglich diesen mechanisch derart fixiert, daß ein guter thermischer Kontakt vorliegt.

Im Betrieb der Energieversorgungsvorrichtung 11 stellt diese dem elektrischen Gerät die notwendige elektrische Energie bereit. Ferner wird die Umwälzpumpe 46 angetrieben, um Kühlungsflüssigkeit durch das bzw. die thermischen Kontaktelemente 52 zu pumpen. Dadurch läßt sich von dem entsprechenden, mit einem thermischen Kontaktelement 52 kontaktierten Gegenstand Wärme abführen. Die aufgeheizte Kühlungsflüssigkeit wird dann dem Radiator 38 zugeführt, an welcher sie abkühlen kann. Ein Luftstrom der Lüftereinrichtung 24 beaufschlagt dabei den Radiator 38 und auch mindestens teilweise die Schaltungsanordnung 20 der Energieversorgungsvorrichtung 11. Die Lüftereinrichtung 24 sorgt dabei gleichzeitig für eine Luftkühlung der aufgeheizten Kühlungsflüssigkeit und für eine Luftkühlung der Schaltungsanordnung 20.

Es ist dabei möglich, daß der Radiator 38 so angeordnet ist, daß abgekühlte Kühlungsflüssigkeit an der Schaltungsanordnung 20 vorbeigeführt wird, um diese - über Kühlungsflüssigkeit - zusätzlich kühlen zu können.

Die Lüftereinrichtung 24 ist eine gemeinsame Lüftereinrichtung für den Radiator 38 und die Energieversorgungsvorrichtung 11 und insbesondere deren Schaltungsanordnung 20.

Die Kühlungsanordnung 10 ist vorzugsweise vorkonfektioniert, das heißt alle notwendigen Komponenten der Flüssigkeitskühlungseinrichtung 40 sind montiert; insbesondere sind der Radiator 38, die Umwälzpumpe 46, die Lüftereinrichtung 24, die Flüssigkeitsleitungen 54, 56 und darüber das oder die thermischen Kontaktelemente 52 montiert. Ferner ist das System mit einer ausreichende Menge an Kühlungsflüssigkeit vorgefüllt, so daß keine Nachbefüllung während der üblichen erwarteten Lebensdauer notwendig ist.

Für die Energieversorgungsvorrichtung 11 muß keine eigene Lüftereinrichtung mehr vorgesehen werden. Dadurch läßt sich die Energieversorgungsvorrichtung 11 kleiner als üblich ausbilden. Der dadurch gewonnene Raum läßt sich wiederum dazu nutzen, um Komponenten einer Flüssigkeitskühlungseinrichtung zu positionieren. Insbesondere kann dann in einem Raum neben der Energieversorgungsvorrichtung 11 die Lüftereinrichtung 24, welche auch für die Kühlung von Kühlungsflüssigkeit in dem Radiator 38 sorgt, positioniert werden. Ferner kann die Umwälzpumpe 46 neben der Energieversorgungsvorrichtung 11 positioniert werden. Auch der Radiator 38 kann neben der Energieversorgungsvorrichtung 11 positioniert werden.

## Patentansprüche

1. Kühlungsanordnung für ein elektrisches Gerät mit einer oder mehreren Wärmequellen, wobei das elektrische Gerät eine elektrische Energieversorgungsvorrichtung (11) mit mindestens einer Wärmequelle aufweist, umfassend eine Lüftereinrichtung (24) zur Kühlung der mindestens einen Wärmequelle der Energieversorgungsvorrichtung (11) mittels eines Luftstroms, und eine Flüssigkeitskühlungseinrichtung (40), **dadurch gekennzeichnet** , daßdieLüftereinrichtung(24) so angeordnet ist, daß ein Radiator (38) der Flüssigkeitskühlungseinrichtung (40) mindestens teilweise mit einem Luftstrom der Lüftereinrichtung (24) beaufschlagbar ist.

2. Kühlungsanordnung nach Anspruch 1, **dadurch gekennzeichnet, daß** die Lüftereinrichtung (24) und der Radiator (38) in Beziehung zu der Energieversorgungsvorrichtung (11) so angeordnet sind, daß die mindestens eine Wärmequelle der Energieversorgungsvorrichtung (11) und der Radiator (38) über die Lüftereinrichtung (24) kühlbar sind.

3. Kühlungsanordnung nach Anspruch 1 oder 2, **dadurch gekennzeichnet, daß** die Energieversorgungsvorrichtung (11) lüfterfrei ausgebildet ist.

4. Kühlungsanordnung nach einem der vorangehenden Ansprüche, **dadurch gekennzeichnet, daß** in einem Raum neben der Energieversorgungsvorrichtung (11) die Lüftereinrichtung (24) angeordnet ist.

5. Kühlungsanordnung nach einem der vorangehenden Ansprüche, **dadurch gekennzeichnet, daß** in einem Raum neben der Energieversorgungsvorrichtung (11) der Radiator (38) angeordnet ist.

6. Kühlungsanordnung nach einem der vorangehenden Ansprüche, **dadurch gekennzeichnet, daß** die Energieversorgungsvorrichtung (11) und die Lüftereinrichtung (24) an einem gemeinsamen Halter (31) angeordnet sind.

7. Kühlungsanordnung nach einem der vorangehenden Ansprüche, **dadurch gekennzeichnet, daß** die Energieversorgungsvorrichtung (11) und der Radiator (38) an einem gemeinsamen Halter (31) angeordnet sind.

8. Kühlungsanordnung nach einem der vorangehenden Ansprüche, **dadurch gekennzeichnet, daß** die Lüftereinrichtung (24) und der Radiator (38) an einem gemeinsamen Halter (31) angeordnet sind.

9. Kühlungsanordnung nach einem der vorangehenden Ansprüche, **dadurch gekennzeichnet, daß** eine Umwälzpumpe (46) der Flüssigkeitskühlungseinrichtung (40) und die Energieversorgungsvorrichtung (11) an einem gemeinsamen Halter angeordnet sind.

10. Kühlungsanordnung nach einem der vorangehenden Ansprüche, **dadurch gekennzeichnet, daß** der Radiator (38) in die Energieversorgungsvorrichtung (11) integriert ist.

11. Kühlungsanordnung nach einem der vorangehenden Ansprüche, **dadurch gekennzeichnet, daß** eine Umwälzpumpe (46) für die Flüssigkeitskühlung vorgesehen ist.

12. Kühlungsanordnung nach Anspruch 11, **dadurch gekennzeichnet, daß** die Umwälzpumpe (46) in die Energieversorgungsvorrichtung (11) integriert ist.

13. Kühlungsanordnung nach Anspruch 11 oder 12, **dadurch gekennzeichnet, daß** die Umwälzpumpe (46) an einem Gehäuse (21) der Energieversorgungsvorrichtung (11) angeordnet ist.

14. Kühlungsanordnung nach einem der Ansprüche 11 bis 13, **dadurch gekennzeichnet, daß** die Umwälzpumpe (46) außerhalb eines Gehäuseinnenraums (49) eines Gehäuses (21) der Energieversorgungsvorrichtung (11) angeordnet ist.

15. Kühlungsanordnung nach einem der Ansprüche 11 bis 14, **dadurch gekennzeichnet, daß** die Umwälzpumpe (46) mit mindestens einem thermischen Kontaktelement (52) verbunden ist.

16. Kühlungsanordnung nach einem der Ansprüche 11 bis 15, **dadurch gekennzeichnet, daß** mindestens ein thermisches Kontaktelement (52) mit der Umwälzpumpe (46) über Flüssigkeitsleitungen (54, 56) derart verbunden ist, daß durch das mindestens eine thermische Kontaktelement (52) eine Wärmequelle thermisch kontaktierbar ist.

17. Kühlungsanordnung nach einem der Ansprüche 11 bis 16, **dadurch gekennzeichnet, daß** in der Strömungsführung für Kühlungsflüssigkeit bezogen auf eine Strömungsrichtung für aufgeheizte Kühlungsflüssigkeit die Umwälzpumpe (46) vor dem Radiator (38) angeordnet ist.

18. Kühlungsanordnung nach einem der Ansprüche 11 bis 17, **dadurch gekennzeichnet, daß** die Umwälzpumpe (46) an oder in der Nähe einer Durchführung (51) der Energieversorgungsvorrichtung (11) für einen Kabelstrang (53) angeordnet ist.

19. Kühlungsanordnung nach einem der Ansprüche 11 bis 18, **dadurch gekennzeichnet, daß** die Umwälzpumpe (46) an einer Halteplatte (47) angeordnet ist, welche einem elektrischen Anschluß (22) der Energieversorgungsvorrichtung (11) gegenüberliegt.

20. Kühlungsanordnung nach einem der Ansprüche 11 bis 19, **dadurch gekennzeichnet, daß** eine Rotationsachse (34) der Lüftereinrichtung (24) quer zu einer Rotationsachse (45) der Umwälzpumpe (46) orientiert ist.

21. Kühlungsanordnung nach einem der vorangehenden Ansprüche, **dadurch gekennzeichnet, daß** der Radiator (38) und die Lüftereinrichtung (24) hintereinander angeordnet sind.

22. Kühlungsanordnung nach einem der vorangehenden Ansprüche, **dadurch gekennzeichnet, daß** der Radiator (38) unterhalb eines elektrischen Anschlusses (22) der Energieversorgungsvorrichtung (11) angeordnet ist.

23. Kühlungsanordnung nach einem der Ansprüche 11 bis 22, **dadurch gekennzeichnet, daß** die Umwälzpumpe (46) einen Elektromotor mit einem sphärisch gelagerten Rotor aufweist.

24. Kühlungsanordnung nach Anspruch 23, **dadurch gekennzeichnet, daß** ein Schaufelrad der Umwälzpumpe (46) mit dem Rotor verbunden ist.

25. Kühlungsanordnung nach einem der vorangehenden Ansprüche, **dadurch gekennzeichnet, daß** mindestens ein Ausgleichsbehälter (62) für Kühlungsflüssigkeit vorgesehen ist.

26. Kühlungsanordnung nach Anspruch 25, **dadurch gekennzeichnet, daß** der mindestens eine Ausgleichsbehälter (62) neben der Energieversorgungsvorrichtung (11) angeordnet ist.

27. Kühlungsanordnung nach Anspruch 25 oder 26, **dadurch gekennzeichnet, daß** der mindestens eine Ausgleichsbehälter (62) neben einer Umwälzpumpe (46) angeordnet ist.

28. Kühlungsanordnung nach Anspruch 26 oder 27, **dadurch gekennzeichnet, daß** der mindestens eine Ausgleichsbehälter in eine Umwälzpumpe integriert ist.

29. Kühlungsanordnung nach einem der vorangehenden Ansprüche, **gekennzeichnet durch** den Radiator (38), eine Umwälzpumpe (46), einen Ausdehnungsbehälter (62) und die Lüftereinrichtung (24).

30. Kühlungsanordnung nach Anspruch 29, **gekennzeichnet durch** Flüssigkeitsleitungen (54, 56), an welchen mindestens ein thermisches Kontaktelement (52) angeordnet ist.

31. Kühlungsanordnung nach einem der vorangehenden Ansprüche, **dadurch gekennzeichnet, daß** die Flüssigkeitskühlungseinrichtung (40) mit einer solchen Menge an Kühlungsflüssigkeit vorbefüllt ist, daß kein Nachfüllen während einer erwarteten Lebensdauer notwendig ist.

32. Verfahren zur Flüssigkeitskühlung in einer Kühlungsanordnung gemäβ Anspruch1 mit mindestens einer Wärmequelle eines elektrischen Geräts, bei dem ein Luftstrom einer Lüftereinrichtung einen Radiator beaufschlägt,
**dadurch gekennzeichnet** , daßeinLuftstromderLüftereinrichtung auch eine Energieversorgungsvorrichtung des elektrischen Geräts so beaufschlägt, daß eine oder mehrere Wärmequellen der Energieversorgungsvorrichtung mittels des Luftstroms gekühlt werden.

## Claims

1. Cooling assembly for an electrical appliance with one or several heat sources, the electrical appliance having an electrical power supply unit (11) with at least one heat source, comprising a fan device (24) for cooling the at least one heat source of the power supply unit (11) by means of a stream of air, and a liquid cooling device (40), **characterized in that** t the fan device (24) is arranged such that a radiator (38) of the liquid cooling device (40) can be acted upon at least partially by a stream of air from the fan device (24).

2. Cooling assembly in accordance with claim 1, **characterized in that** the fan device (24) and the radiator (38) are arranged with respect to the power supply unit (11) such that the at least one heat source of the power supply unit (11) and the radiator (38) can be cooled via the fan device (24).

3. Cooling assembly in accordance with claim 1 or 2, **characterized in that** the power supply unit (11) is designed to be fan-free.

4. Cooling assembly in accordance with any one of the preceding claims, **characterized in that** the fan device (24) is arranged in a space next to the power supply unit (11).

5. Cooling assembly in accordance with any one of the preceding claims, **characterized in that** the radiator (38) is arranged in a space next to the power supply unit (11).

6. Cooling assembly in accordance with any one of the preceding claims, **characterized in that** the power supply unit (11) and the fan device (24) are arranged on a common support (31).

7. Cooling assembly in accordance with any one of the preceding claims, **characterized in that** the power supply unit (11) and the radiator (38) are arranged on a common support (31).

8. Cooling assembly in accordance with any one of the preceding claims, **characterized in that** the fan (24) device and the radiator (38) are arranged on a common support (31).

9. Cooling assembly in accordance with any one of the preceding claims, **characterized in that** a circulation pump (46) of the liquid cooling device (40) and the power supply unit (11) are arranged on a common support.

10. Cooling assembly in accordance with any one of the preceding claims, **characterized in that** the radiator (38) is integrated into the power supply unit (11).

11. Cooling assembly in accordance with any one of the preceding claims, **characterized in that** a circulation pump (46) is provided for the liquid cooling.

12. Cooling assembly in accordance with claim 11, **characterized in that** the circulation pump (46) is integrated into the power supply unit (11).

13. Cooling assembly in accordance with claim 11 or 12, **characterized in that** the circulation pump (46) is arranged on a housing (21) of the power supply unit (11).

14. Cooling assembly in accordance with any one of claims 11 to 13, **characterized in that** the circulation pump (46) is arranged outside a housing interior (49) of a housing (21) of the power supply unit (11).

15. Cooling assembly in accordance with any one of claims 11 to 14, **characterized in that** the circulation pump (46) is connected to at least one thermal contact element (52).

16. Cooling assembly in accordance with any one of claims 11 to 15, **characterized in that** at least one thermal contact element (52) is connected to the circulation pump (46) via liquid lines (54, 56) in such a manner that a heat source can be contacted thermally by the at least one thermal contact element (52).

17. Cooling assembly in accordance with any one of claims 11 to 16, **characterized in that** in the flow guidance for cooling liquid the circulation pump (46) is arranged upstream of the radiator (38) with respect to a direction of flow for heated cooling liquid.

18. Cooling assembly in accordance with any one of claims 11 to 17, **characterized in that** the circulation pump (46) is arranged at or in the vicinity of a feed-through (51) of the power supply unit (11) for a loom of cables (53).

19. Cooling assembly in accordance with any one of claims 11 to 18, **characterized in that** the circulation pump (46) is arranged on a supporting plate (47) located opposite an electrical connection (22) of the power supply unit (11).

20. Cooling assembly in accordance with any one of claims 11 to 19, **characterized in that** an axis of rotation (34) of the fan device (24) is oriented transversely to an axis of rotation (45) of the circulation pump (46).

21. Cooling assembly in accordance with any one of the preceding claims, **characterized in that** the radiator (38) and the fan device (24) are arranged one behind the other.

22. Cooling assembly in accordance with any one of the preceding claims, **characterized in that** the radiator (38) is arranged beneath an electrical connection (22) of the power supply unit (11).

23. Cooling assembly in accordance with any one of claims 11 to 22, **characterized in that** the circulation pump (46) has an electric motor with a spherically mounted rotor.

24. Cooling assembly in accordance with claim 23, **characterized in that** a blade wheel of the circulation pump (46) is connected to the rotor.

25. Cooling assembly in accordance with any one of the preceding claims, **characterized in that** at least one compensation reservoir (62) for cooling liquid is provided.

26. Cooling assembly in accordance with claim 25, **characterized in that** the at least one compensation reservoir (62) is arranged next to the power supply unit (11).

27. Cooling assembly in accordance with claim 25 or 26, **characterized in that** the at least one compensation reservoir (62) is arranged next to a circulation pump (46).

28. Cooling assembly in accordance with claim 26 or 27, **characterized in that** the at least one compensation reservoir is integrated into a circulation pump.

29. Cooling assembly in accordance with any one of the preceding claims, **characterized by** the radiator (38), a circulation pump (46), an expansion reservoir (62) and the fan device (24).

30. Cooling assembly in accordance with claim 29, **characterized by** liquid conduits (54, 56), at which at least one thermal contact element is arranged.

31. Cooling assembly in accordance with any one of the preceding claims, **characterized in that** the liquid cooling device (40) is prefilled with such an amount of cooling liquid that no subsequent filling is necessary during an expected service life.

32. Method for liquid cooling in a cooling assembly in accordance with claim 1 with at least one heat source of an electrical appliance, wherein a stream of air from a fan device acts upon a radiator,
**characterized in that** a stream of air from the fan device also acts upon a power supply unit of the electrical appliance such that one or more heat sources of the power supply unit are cooled by means of the stream of air.

## Revendications

1. Agencement de refroidissement pour un appareil électrique avec une ou plusieurs sources de chaleur, ledit appareil électrique comprenant un dispositif d'alimentation en énergie électrique (11) avec au moins une source de chaleur, comprenant un système à ventilateur (24) pour refroidir ladite au moins une source de chaleur du dispositif d'alimentation en énergie (11) au moyen d'un flux d'air, et un système de refroidissement à liquide (40),
**caractérisé en ce que** le système à ventilateur (24) est agencé de telle façon qu'un radiateur (38) du système de refroidissement à liquide (40) est susceptible d'être balayé au moins partiellement avec un flux d'air du système à ventilateur (24).

2. Agencement de refroidissement selon la revendication 1, **caractérisé en ce que** le système à ventilateur (24) et le radiateur (38) sont agencés, par rapport au dispositif alimentation en énergie (11), de telle façon que ladite au moins une source de chaleur du dispositif d'alimentation en énergie (11) et le radiateur (38) peuvent être refroidis via le système à ventilateur (24).

3. Agencement de refroidissement selon la revendication 1 ou 2, **caractérisé en ce que** le dispositif d'alimentation en énergie (11) est réalisé sans ventilateur.

4. Agencement de refroidissement selon l'une des revendications précédentes, **caractérisé en ce que** le système à ventilateur (24) est agencé dans un espace à côté du dispositif d'alimentation en énergie (11).

5. Agencement de refroidissement selon l'une des revendications précédentes, **caractérisé en ce que** le radiateur (38) est agencé dans un espace à côté du dispositif d'alimentation en énergie (11).

6. Agencement de refroidissement selon l'une des revendications précédentes, **caractérisé en ce que** le dispositif d'alimentation en énergie (11) et le système à ventilateur (24) sont agencés sur un support commun (34).

7. Agencement de refroidissement selon l'une des revendications précédentes, **caractérisé en ce que** le dispositif d'alimentation en énergie (11) et le radiateur (38) sont agencés sur un support commun (31).

8. Agencement de refroidissement selon l'une des revendications précédentes, **caractérisé en ce que** le système à ventilateur (24) et le radiateur (38) sont agencés sur un support commun (31).

9. Agencement de refroidissement selon l'une des revendications précédentes, **caractérisé en ce qu'**une pompe de recirculation (46) du système de refroidissement à liquide (40) et le dispositif d'alimentation en énergie (11) sont agencés sur un support commun.

10. Agencement de refroidissement selon l'une des revendications précédentes, **caractérisé en ce que** le radiateur (38) est intégré dans le dispositif d'alimentation en énergie (11).

11. Agencement de refroidissement selon l'une des revendications précédentes, **caractérisé en ce qu'**il est prévu une pompe de recirculation (46) pour le refroidissement par liquide.

12. Agencement de refroidissement selon la revendication 11, **caractérisé en ce que** la pompe de recirculation (46) est intégrée dans le dispositif d'alimentation en énergie (11).

13. Agencement de refroidissement selon la revendication 11 ou 12, **caractérisé en ce que** la pompe de recirculation (46) est agencée sur un boîtier (21) du dispositif d'alimentation en énergie (11).

14. Agencement de refroidissement selon l'une des revendications 11 à 13, **caractérisé en ce que** la pompe de recirculation (46) est agencée à l'extérieur d'un espace intérieur (49) d'un boîtier (21) du dispositif d'alimentation en énergie (11).

15. Agencement de refroidissement selon l'une des revendications 11 à 14, **caractérisé en ce que** la pompe de recirculation (46) est reliée à au moins un élément de contact thermique (52).

16. Agencement de refroidissement selon l'une des revendications 11 à 15, **caractérisé en ce qu'**au moins un élément de contact thermique (52) est relié à la pompe de recirculation (46) via des conduites à liquide (54, 56) de telle façon qu'une source de chaleur peut être amenée en contact thermique via ledit au moins un élément de contact thermique (52).

17. Agencement de refroidissement selon l'une des revendications 11 à 16, **caractérisé en ce que** la pompe de recirculation (46) est agencée devant le radiateur (38) dans le guidage de l'écoulement pour le liquide de refroidissement par référence à une direction d'écoulement pour un liquide de refroidissement échauffé.

18. Agencement de refroidissement selon l'une des revendications 11 à 17, **caractérisé en ce que** la pompe de recirculation (46) est agencée au niveau ou au voisinage d'une traversée (51) du dispositif d'alimentation en énergie (11) pour un faisceau de câbles (53)

19. Agencement de refroidissement selon l'une des revendications 11 à 18, **caractérisé en ce que** la pompe de recirculation (46) est agencée sur une plaque de maintien (47) qui est opposée à un raccordement électrique (22) du dispositif d'alimentation en énergie (11).

20. Agencement de refroidissement selon l'une des revendications 11 à 19, **caractérisé en ce qu'**un axe de rotation (34) du système à ventilateur (24) est orienté transversalement à un axe de rotation (45) de la pompe de recirculation (46).

21. Agencement de refroidissement selon l'une des revendications précédentes, **caractérisé en ce que** le radiateur (38) et le système à ventilateur (24) sont agencés l'un derrière l'autre.

22. Agencement de refroidissement selon l'une des revendications précédentes, **caractérisé en ce que** le radiateur (38) est agencé au-dessous d'un raccordement électrique (22) du dispositif d'alimentation en énergie (11).

23. Agencement de refroidissement selon l'une des revendications 11 à 22, **caractérisé en ce que** la pompe de recirculation (46) comprend un moteur électrique avec un rotor à montage sphérique.

24. Agencement de refroidissement selon la revendication 23, **caractérisé en ce qu'**une roue à aubes de la pompe de recirculation (46) est reliée avec le rotor.

25. Agencement de refroidissement selon l'une des revendications précédentes, **caractérisé en ce qu'**il est prévu au moins un récipient de compensation (62) pour le liquide de refroidissement.

26. Agencement de refroidissement selon la revendication 25, **caractérisé en ce que** ledit au moins un récipient de compensation (62) est agencé à côté du dispositif d'alimentation en énergie (11).

27. Agencement de refroidissement selon la revendication 25 ou 26, **caractérisé en ce que** ledit au moins un récipient de compensation (62) est agencé à côté d'une pompe de recirculation (46).

28. Agencement de refroidissement selon la revendication 26 ou 27, **caractérisé en ce que** ledit au moins un récipient de compensation est intégré dans une pompe de recirculation.

29. Agencement de refroidissement selon l'une des revendications précédentes, **caractérisé par** un radiateur (38), une pompe de recirculation (46), un vase d'expansion (62) et un système à ventilateur (24).

30. Agencement de refroidissement selon la revendication 29, **caractérisé par** des conduites à liquide (54, 56) sur lesquelles est agencé au moins un élément de contact thermique (52).

31. Agencement de refroidissement selon l'une des revendications précédentes, **caractérisé en ce que** le système de refroidissement par liquide (40) est préalablement rempli de liquide de refroidissement dans une quantité telle qu'il n'est pas nécessaire de compléter le remplissage pendant une durée de vie prévisible.

32. Procédé pour le refroidissement par liquide, dans un agencement de refroidissement selon la revendication 1 d'au moins une source de chaleur d'un appareil électrique, dans lequel un flux d'air d'un système à ventilateur balaye un radiateur,
**caractérisé en ce qu'**un flux d'air du système à ventilateur balaye également un dispositif d'alimentation en énergie de l'appareil électrique de telle façon qu'une ou plusieurs sources de chaleur du dispositif d'alimentation en énergie sont refroidies au moyen du flux d'air.
